Europäisches Patentamt

European Patent Office

Office européen des brevets

(11) Publication number: **0 316 104**
**A2**

# EUROPEAN PATENT APPLICATION

(21) Application number: **88310302.0**

(51) Int. Cl.⁴: **H01L 27/06**

(22) Date of filing: **02.11.88**

| | |
|---|---|
| The title of the invention has been amended (Guidelines for Examination in the EPO, A-III, 7.3). | (71) Applicant: **STC PLC**<br>**10, Maltravers Street**<br>**London, WC2R 3HA(GB)** |
| (30) Priority: **03.11.87 GB 8725688**<br>**16.02.88 GB 8803505** - | (72) Inventor: **Harris, Jeffery Peter**<br>**47, Broadleaf Avenue Bishop's Stortford**<br>**Hertfordshire CM23 4JZ(GB)**<br>Inventor: **Hunt, Robert William**<br>**Oakfield West Street** |
| (43) Date of publication of application:<br>**17.05.89 Bulletin 89/20** | **Hunton Near Maidstone, Kent, ME15 0RV(GB)**<br>Inventor: **Young, John Michael**<br>**46, Paddock Mead** |
| (84) Designated Contracting States:<br>**BE DE FR GB IT NL** | **Harlow Essex CM18 7RR(GB)**<br>Inventor: **Baker, Roger Leslie**<br>**7, Third Avenue**<br>**Chelmsford Essex(GB)** |
| | (74) Representative: **Ryan, John Peter William et al**<br>**STC Patents West Road**<br>**Harlow Essex CM20 2SH(GB)** |

(54) Integrated circuits comprising resistors and bipolar transistors.

(57) In an integrated circuit incorporating both polysilicon emitter transistors and polysilicon resistors, the emitters and resistors are formed simultaneously from a common polysilicon layer. Applications of the technique are described.

Fig.1.

EP 0 316 104 A2

**IMPROVEMENTS IN INTEGRATED CIRCUITS.**

This invention relates to integrated circuits and in particular to the provision of resistors in integrated circuits.

A significant problem in the manufacture of integrated circuits is the provision of resistors. Conventionally, resistors are provided as diffused regions each disposed on a separate resistor island or isolation land. Such an arrangement is comparatively bulky and represents a severe limitation on the density of integration that can be achieved. A further disadvantage of the diffused resistor is the difficulty of providing accurate resistor values. This is a particular problem when two or more resistors are to be 'matched' so as to carry substantially equal currents. In an attempt to overcome the disadvantage of diffused resistors, processes have been developed in which resistors are formed from polycrystalline silicon (polysilicon). However, this has required processing steps additional to those necessary for forming the active devices of a circuit. This increases the unit cost of the circuit and, in some circumstances, can result in a reduction of yield.

The object of the present invention is to minimise or to overcome these disadvantages.

According to the invention there is provided an integrated circuit, including a plurality of polysilicon emitter bipolar transistors, and a plurality of polysilicon resistors associated with the transistors, characterised in that the resistors and the transistor emitter are formed from a common polysilicon deposition.

By forming the resistors simultaneously with, and from the same material as, the transistor emitters, no additional processing is required.

Embodiments of the invention will now be described with reference to the accompanying drawings in which:-

Figure 1 illustrates the construction of a polysilicon emitter transistor and an associated resistor in an integrated circuit;

Figures 2 and 3 illustrate an integrated circuit construction utilising the fabrication techniques of Figure 1.

and Figure 4 illustrates an alternative integrated circuit construction.

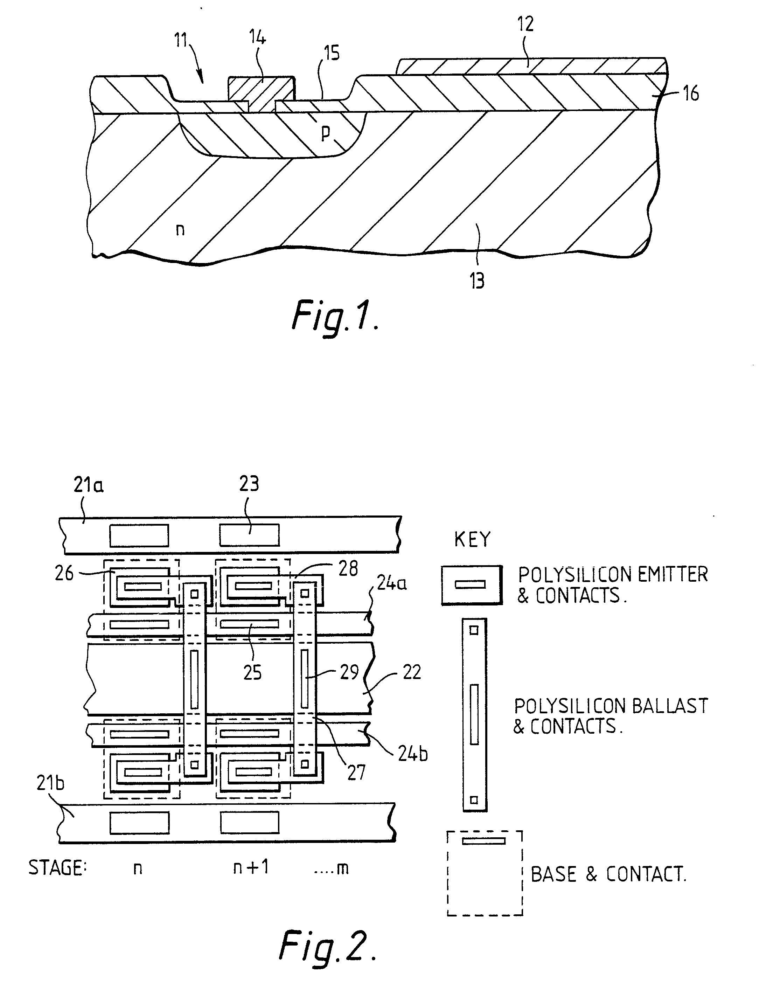

Referring to Figure 1, which shows only those parts of the circuit construction necessary for the understanding of the invention, there is illustrated the simultaneous fabrication of a polysilicon emitter transistor 11 and a polysilicon resistor 12. The structure is formed on a single crystal silicon substrate 13. The transistor emitter comprises a body 14 of polysilicon which contacts the substrate via an opening in a thin oxide layer 15. The resistor 12 is isolated from the substrate by a thicker oxide layer 16. The emitter body 14 and the resistor 12 are formed from a common polysilicon layer which is then selectively etched to define those two elements. Advantageously, the bipolar transistor is incorporated in a circuit structure including field effect (MOS) transistors. In such an arrangement the MOS transistor gates are also formed from the common polysilicon layer. The fabrication if circuit structures incorporating polysilicon emitter transistors is defined in detail in our UK specification No. 2, 174, 244.

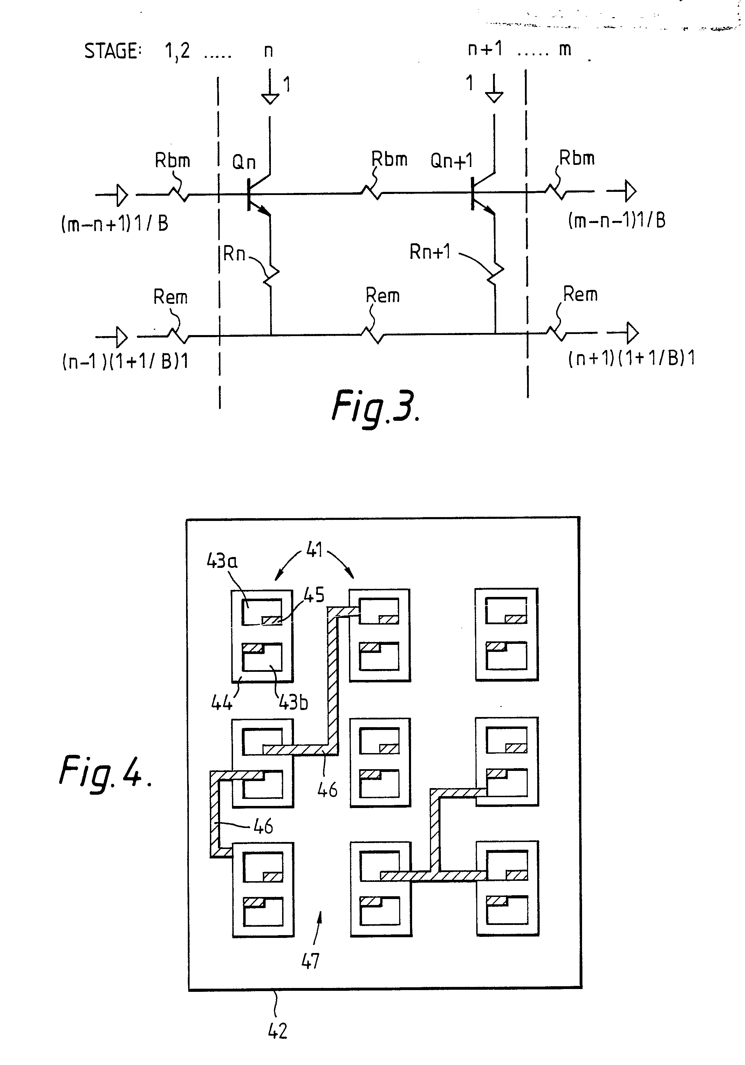

An application of the technique described above is illustrated in Figures 2 and 3 of the accompanying drawings. Referring to Figure 2, there is shown part of an array of adjacent npn bipolar power transistors in an integrated circuit. The transistors are disposed between supply rails 21a, 21b and a ground rail 22, each rail comprising e.g. a metal track. The supply rails are coupled to the collectors of the transistors via contacts 23. Base current is supplied to the transistors via a further pair of metal tracks 24c, 24b provided with base contacts 25.

The transistors are provided with polysilicon emitters 26. Typically the transistors are formed by a process as described in our UK specification No. 2, 174, 244 (P.D. Scovell et al 15-13-8 Div A). The emitter of each transistor is coupled to a polysilicon ballast resistor 27 via a metallisation 28. The ballast resistors 27 are coupled to the ground rail 22 via contacts 29. Both the transistor emitters 26 and the polysilicon resistors 27 are formed by selective etching of a common polysilicon layer. The polysilicon forming the ballast resistors is deposited on oxide (not shown) so that electrical isolation is provided between the base metal lines 24a and 24b and the resistors. The resistors can thus be disposed over the transistor collector resulting in an efficient use of chip area. The value of each polysilicon resistor is determined by its width which in turn is determined by a particular patterning of the mask used to define these resistors. The manner in which this is performed can be seen from reference to Figure 3 of the drawings. It can be shown that the difference between adjacent ballast resistors $R_n$ and $R_n + 1$ is given by the expression

$$Rn - R_{n+1} = \frac{(m - n) R_{bm}}{(B + 1) - nR_{em}}$$

where $R_{bm}$ and $R_{em}$ are the base and emitter resistive increments respectively, m is the total members of emitters and B is the small rigid current gain. The average voltage drop across the ballast resistors should be chosen high enough so that the emitters operate at the same current densities but not so high as to effect the overall saturation voltage. Ballast resistor voltage drops of 50mV are suitable.

As the polysilicon resistors are oxide isolated and no separate resistor isolation land is required, the arrangement is very compact.

A further application of the technique is illustrated in Figure 4 of the accompanying drawings. This Figure depicts a bipolar analogue array comprising a plurality of similar cells 41 of transistors disposed on a common semiconductor substrate 42. In the structure of Figure 4 each cell consists of a pair of bipolar transistors each having a base 43a 43b, disposed in a common collector 14. Each transistor has a polycrystalline silicon (polysilicon) emitter body 45. Selected transistors of the array are coupled via polysilicon resistor tracks 46 routed via corridors 47 between the cells of array. These resistors are deposited simultaneously with the transistor emitters using a customising mask. This provides the array with its desired circuit function. The polysilicon may be doped or undoped.

After provision of the polysilcion resistor pattern a further customising mask is employed to provide a desired metal interconnect (not shown). The chip is then mounted in a suitable package.

As the resistors are not formed until the latter part of the process there is no necessity to provide redundant resistors. This eases the constraints on chip space and simplifies the interconnection layout. Moreover the resistors can be configured by a custom mask. This allows resistors of any required value to be placed at will or any part of the die. The metal routing task is thus reduced to that of interconnecting the transistors as required, the resistors being placed in the optimum positions to comply with positioning of the transistors interconnections.

It will be appreciated that, whilst the technique has been described with particular reference to bipolar circuits, it is also applicable to circuits incorporating both bipolar and field effect devices. Typically these field effect devices comprise complementary pairs of (CMOS) transistors.

## Claims

1. An integrated circuit, including a plurality of polysilicon emitter bipolar transistors, and a plurality of polysilicon resistors associated with the transistors, characterised in that the resistors and the transistor emitter are formed from a common polysilicon deposition.

2. An integrated circuit, as claimed in claim 1, characterised in that the circuit includes polysilicon emitter resistor one for each said transistor, and that the relative values of the resistors are such that, in use, matching of the currents carried by the transistors is provided.

3. An integrated circuit as claimed in claim 2, characterised in that adjacent resistors have values $R_n$ and $R_{n-1}$ given by the expression

$$Rn - R_{n+1} = \frac{(m - n) R_{bm}}{(B + 1) - nR_{em}}$$

where $R_{bm}$ and $R_{em}$ are respectively the base and emitter resistive increments and m is the total number of transistor emitters.

4. An integrated circuit as claimed in claim 1, characterised in that the circuit comprises a plurality of similar cells of bipolar transistors adapted to provide particular circuit functions by corresponding interconnection of the transistors, and a plurality of resistors whereby selected cells are coupled to define a predetermined circuit function.

5. An integrated circuit as claimed in any of claims 1 to 4, characterised in that each polysilicon resistor is disposed on a insulating oxide layer.

6. An integrated circuit as claimed in any of claims 1 to 5, characterised in that the circuit further includes field effect transistors.

*Fig.1.*

KEY

POLYSILICON EMITTER
& CONTACTS.

POLYSILICON BALLAST
& CONTACTS.

BASE & CONTACT.

STAGE:     n     n+1   ....m

*Fig.2.*

STAGE: 1,2 .....     n       n + 1 ..... m

$Fig.3.$

$Fig.4.$